# FASCICULE DE BREVET EUROPEEN

(11) **EP 3 571 721 B1**
(45) Date de publication et mention de la délivrance du brevet: **19.05.2021**
(21) Numéro de dépôt: 18702766.9
(22) Date de dépôt: 17.01.2018
(51) Int. Cl.: H01L 27/146

(54) **PROCÉDÉ DE RÉALISATION COLLECTIVE DE CIRCUITS ÉLECTRONIQUES COURBES**
VERFAHREN ZUR MASSENHERSTELLUNG GEKRÜMMTER ELEKTRONISCHER SCHALTUNGEN
METHOD FOR MASS-PRODUCTION OF CURVED ELECTRONIC CIRCUITS

(30) Priorité: 18.01.2017 FR 1750377
(43) Date de publication de la demande: 27.11.2019
(73) Titulaire: Commissariat à l'énergie atomique et aux énergies alternatives, 75015 Paris (FR); Centre National de la Recherche Scientifique, 75794 Paris Cedex 16 (FR); Université d'Aix Marseille, 13284 Marseille Cedex 07 (FR)
(72) Inventeur: CHAMBION, Bertrand, 38530 Poncharra (FR); HUGOT, Emmanuel, 13006 Marseille (FR)
(74) Mandataire: Brevalex
(86) Numéro de dépôt international: PCT/FR2018/050113
(87) Numéro de publication internationale: WO 2018/134520

(56) Documents cités:
- US-A1- 2006 186 492
- US-A1- 2016 086 994
- US-A1- 2016 286 102

## Description

### DOMAINE TECHNIQUE ET ART ANTÉRIEUR

L'invention porte sur le domaine de la réalisation collective de circuits électroniques courbés, c'est-à-dire non plans, ainsi que celui de la réalisation de dispositifs électroniques comportant de tels circuits électroniques courbés couplés à des systèmes optiques, par exemple de type imageur (ou capteur) ou afficheur.

Un dispositif électronique tel qu'un capteur ou un afficheur comporte un système optique, formé généralement de plusieurs lentilles, couplé à un circuit électronique destiné à réaliser une émission ou une détection de lumière à travers le système optique. Le circuit électronique comporte un substrat sur lequel sont réalisés plusieurs composants électroniques.

Le fait de courber le circuit électronique est une solution qui permet de simplifier fortement le système optique, en réduisant notamment le nombre de lentilles nécessaires au système optique, ce qui permet une réalisation plus compacte du système optique. Un exemple de simplification d'optique grand angle est décrit par exemple dans le document « Tunable curvature of large visible CMOS image sensors: Towards new optical functions and system miniaturization » de B. Chambion et al., 2016 IEEE 66th Electronic Components and Technology Conférence (ECTC).

Les substrats à partir desquels les composants électroniques des circuits sont réalisés sont généralement en silicium. Les techniques et procédés de packaging permettent de réduire l'épaisseur du substrat jusqu'à des épaisseurs relativement faibles (quelques microns). Pour réaliser un circuit électronique courbé, une fois le substrat des composants du circuit aminci à l'épaisseur voulue, le circuit électronique est packagé, ou assemblé, sur un support qui est compatible avec la courbure recherchée.

Dans le document précédemment cité de B. Chambion et al, il est décrit un support particulier sur lequel le circuit électronique est collé. La courbure est ensuite obtenue en appliquant ponctuellement une force contre le support, au centre du côté opposé à celui où se trouve le circuit électronique. Dans ce procédé, il est toutefois nécessaire que la force courbant le support soit constamment appliquée sur le support, ce qui représente une contrainte importante.

Le document US 2014/0160327 A1 décrit l'utilisation d'un support dans lequel est formée une cavité. Un circuit électronique est disposé sur le support, au-dessus de la cavité. Le circuit est ensuite courbé par une mise en dépression de cette cavité, et figé dans cette position par de la colle injectée entre le circuit et le support. Cette solution ne permet toutefois l'obtention d'une courbure sphérique qu'au niveau d'une partie centrale du circuit. De plus, elle engendre des contraintes mécaniques importantes au niveau des bords du circuit électronique, ce qui le fragilise.

De manière alternative, le document WO 2012/172251 A1 décrit la réalisation d'un circuit électronique courbé faisant appel à un support formé de deux matériaux ayant des coefficients d'expansion thermique différents. La courbure est obtenue par un effet bilame entre les deux matériaux du support qui ont des comportements thermomécaniques différents. Ce procédé n'est toutefois pas adapté à une réalisation collective de plusieurs circuits électroniques courbés puisque les différents circuits électroniques réalisés à partir d'un même substrat doivent être découpés avant d'être disposés individuellement chacun sur un support. De plus, le choix du niveau de courbure des circuits se fait par ajustement de la température à laquelle le support est soumis, ce qui est contraignant notamment lorsque le circuit électronique correspond à un imageur du fait que son fonctionnement est extrêmement sensible à la température (une augmentation de la température réalisée pour ajuster la courbure dégrade la qualité de l'image fournie par l'imageur en raison de l'augmentation du bruit engendrée par l'augmentation de la température).

Les documents US 2011/0149423 A1, US 2009/0045510 A1 et EP 2 320 469 A1 décrivent d'autres procédés permettant de courber des circuits électroniques. Toutefois, aucun de ces procédés n'est adapté pour réaliser collectivement plusieurs circuits électroniques courbés. Le document US 2006/186492 A1 décrit un procédé de réalisation de plusieurs capteurs d'image courbés.

Le document US 2006/0038183 A1 décrit un procédé permettant de courber collectivement plusieurs circuits électroniques réalisés sur un même substrat. Pour cela, un compartiment contenant un fluide est positionné sous chaque circuit de façon à appliquer une force hydrostatique sous chaque circuit. La courbure des circuits est obtenue par l'intermédiaire de cette force hydrostatique. Ce procédé a toutefois plusieurs inconvénients. En effet, la courbure obtenue varie avec la température à laquelle le fluide est soumis. Il est donc difficile d'obtenir une courbure précise des circuits électroniques. De plus, cette solution n'est pas fiable car en cas de fuite du fluide, la courbure des circuits doit être réajustée.

Le document « A hemispherical electronic eye camera based on compressible silicon optoelectronics » de Heung Cho Ko et al., Nature Letters, vo. 454/7, 7/08/2008, décrit un procédé de réalisation d'un imageur dans lequel une membrane PDMS courbe est contrainte pour la rendre plane avant un collage de composants sur cette membrane. Le circuit électronique collé sur la membrane est particulier car il est formé de plusieurs composants électroniques réalisés sur les portions de silicium qui ne forment pas un même substrat mais qui sont reliés entre eux par des éléments d'interconnexions distincts. Après ce collage, la contrainte sur la membrane est relâchée afin que celle-ci reprenne sa forme initiale.

Là encore, un tel procédé présente plusieurs inconvénients. Tout d'abord, ce procédé ne peut être mis en œuvre que pour le circuit électronique particulier décrit dans ce document et formé par de multiples composants reliés entre eux par des interconnexions aptes à se comprimer. Ce procédé ne permet pas de courber directement les composants électroniques reportés sur la membrane car ce sont les interconnexions qui, en se comprimant, suivent la courbure de la membrane. Lorsque chaque composant est considéré de manière individuelle, ces composants ne sont pas courbés. De plus, au cours du procédé, la membrane est aplanie en appliquant une force latérale sur toute la périphérie de la membrane. Ce procédé n'est donc pas compatible avec une réalisation collective de plusieurs circuits électroniques courbés. De plus, le fait de construire le circuit avec de multiples composants discrets ne permet pas l'obtention d'un système à haute résolution.

### EXPOSÉ DE L'INVENTION

Un but de la présente invention est de proposer un procédé de réalisation collective de plusieurs circuits électroniques courbés ne présentant pas les inconvénients de l'art antérieur, c'est-à-dire :
- dans lequel la courbure est imposée aux composants électroniques des circuits sans avoir à maintenir une force extérieure sur le support des composants,
- qui soit compatible avec l'obtention d'une courbure sphérique de toute la surface des composants électroniques,
- qui ne fragilise pas les bords des circuits électroniques,
- dont la dépendance de la courbure des circuits électroniques vis-à-vis de la température soit réduite ou supprimée,
- qui permet de courber directement les composants électroniques des circuits selon un rayon de courbure imposé par le support.

Pour cela, la présente invention propose un procédé de réalisation de plusieurs circuits électroniques courbés, comprenant :
- réalisation d'un support comprenant plusieurs membranes formées d'au moins un matériau de rigidité, ou module de Young, supérieure à environ 100 MPa, chacune destinée à faire partie d'un des circuits électroniques et présentant un rayon de courbure R compris entre environ 15 mm et 500 mm ;
- application d'une force contre l'une des faces principales de chacune des membranes telle que ladite membrane se déforme élastiquement et ait une forme sensiblement plane sous l'effet de cette force ;
- solidarisation d'au moins un composant électronique contre chacune des membranes ;
- retrait de la force appliquée contre l'une des faces principales de chacune des membranes telle que chacune des membranes retrouve son rayon de courbure R initial et courbe le composant électronique selon ce rayon de courbure R.

La courbure des circuits électroniques est ici obtenue grâce à un stockage temporaire d'énergie élastique dans les membranes. La courbure des membranes au repos correspond à la courbure finale recherchée pour les circuits électroniques. Après leur réalisation, les membranes sont mises sous contrainte pour présenter une surface plane, permettant d'effectuer le collage ou le montage « à plat » du ou des composants électroniques de chaque circuit électronique qui forment par exemple un capteur ou un afficheur. Une fois la force retirée, les membranes reprennent leur position initiale qu'elles imposent aux composants électroniques, formant ainsi les circuits électroniques courbés.

Les membranes et la force appliquée sur ces membranes au cours du procédé sont telles que les membranes sont déformées élastiquement, c'est-à-dire déformées de manière réversible. Ainsi, après le retrait de la force appliquée sur chacune des membranes, elles reprennent leur forme initiale sans rupture ou déformation plastique.

Dans ce procédé, du fait que la force est appliquée contre l'une des faces principales de chacune des membranes et non au niveau des côtés, ou faces latérales, des membranes, la déformation des membranes peut être obtenue simultanément pourtoutes les membranes, ce qui rend le procédé compatible avec une réalisation collective des circuits électroniques courbés.

De plus, le matériau des membranes présente une rigidité importante ce qui permet aux membranes d'appliquer aux composants électroniques leur courbure, même lorsque les composants électroniques sont réalisés sur des portions de substrat aminci de silicium, ces portions de substrat aminci étant donc également courbées par les membranes. La rigidité importante du matériau des membranes permet également de rendre le procédé compatible avec une courbure importante des circuits électroniques, correspondant à l'obtention d'un rayon de courbure R compris entre environ 15 mm et 500 mm.

En outre, la réalisation initiale des membranes avec la courbure désirée rend le procédé compatible avec l'obtention d'une courbure sphérique sur toute la surface de chaque circuit électronique.

De plus, en restant dans le domaine de la déformation élastique, aucune fragilisation des bords des membranes ne se produit.

En outre, ce procédé ne fait pas appel à des matériaux ayant différents CTE (coefficient d'expansion thermique) pour obtenir la courbure souhaitée par effet bilame, ce qui rend la courbure des circuits électroniques indépendante de la température à laquelle sont soumis les circuits électroniques. La courbure obtenue est également plus précise.

Ce procédé est compatible avec une courbure concave ou convexe des composants électroniques des circuits courbés réalisés.

Le matériau des membranes peut être un matériau plastique et le support peut être réalisé par moulage ou par impression 3D. En variante, le matériau des membranes peut être un matériau métallique et le support peut être réalisé par usinage ou par emboutissage.

La force appliquée contre l'une des faces principales de chacune des membranes peut être une force hydrostatique appliquée sur l'ensemble de ladite face principale, ou une force ponctuelle.

Chacune des membranes peut avoir une courbure sphérique ou cylindrique.

Lorsque chacune des membranes a une courbure sphérique et que la force appliquée est ponctuelle, chacune des membranes peut comporter une épaisseur variable décroissante (linéaire ou non) depuis le centre de la membrane jusque vers les bords de la membrane. Autrement dit, l'épaisseur de chaque membrane au niveau de son centre est supérieure à son épaisseur au niveau de ses bords. Une telle épaisseur variable permet l'obtention d'une courbure sphérique même lorsque la force appliquée est ponctuelle.

La force peut être appliquée sur une première des faces principales de chacune des membranes et chaque composant électronique peut être solidarisé contre une deuxième des faces principales de chacune des membranes, opposée à la première des faces principales.

Chaque composant électronique peut être solidarisé contre l'une des membranes par l'intermédiaire d'au moins une couche de collage.

Le procédé peut comporter en outre, après l'étape de retrait de la force appliquée contre l'une des faces principales de chacune des membranes, une étape de découpe du support désolidarisant les circuits électroniques les uns des autres.

L'invention porte également sur un procédé de réalisation de dispositifs électroniques, comportant la mise en œuvre d'un procédé de réalisation de circuits électroniques tel que décrit ci-dessus, puis d'une étape de couplage de chaque circuit électronique avec un système optique, formant les dispositifs électroniques.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 4 représentent les étapes d'un procédé de réalisation d'un circuit électronique courbé, objet de la présente invention, selon un mode de réalisation particulier ;
- la figure 5 représente des valeurs du rayon de courbure minimal pouvant être obtenu dans le procédé de réalisation d'un circuit électronique courbé, objet de la présente invention, en fonction des dimensions d'un substrat sur lequel les composants électroniques du circuit sont réalisés ;
- la figure 6 représente schématiquement un dispositif électronique obtenu par la mise en œuvre d'un procédé selon l'invention ;
- la figure 7 représente schématiquement un circuit électronique obtenu par la mise en œuvre d'un procédé selon l'invention et solidarisé à un support.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

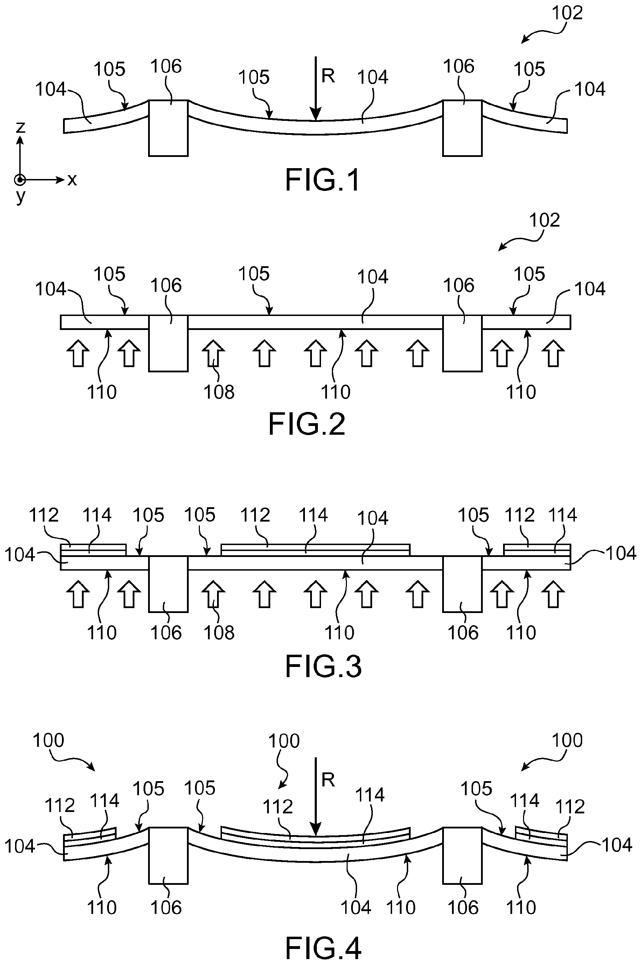

On se réfère tout d'abord aux figures 1 à 4 qui représentent les étapes d'un procédé de réalisation de plusieurs circuits électroniques 100 courbés, selon un mode de réalisation particulier. Dans ce mode de réalisation particulier, les circuits électroniques 100 correspondent à des imageurs CMOS dont les composants électroniques sont réalisés préalablement sur un substrat de silicium aminci à une épaisseur compatible avec une mise en courbure sphérique concave dont le rayon de courbure finale est R, avec R > 15 mm et R < 500 mm. Les circuits électroniques 100 peuvent également correspondre à des imageurs CCD, ou tout autre circuit électronique.

Dans le procédé décrit ici, plusieurs circuits électroniques courbés 100 sont réalisés collectivement à partir d'un même support 102.

Comme représenté sur la figure 1, le support 102 est tout d'abord réalisé. Ce support 102 est destiné à recevoir les composants électroniques des circuits électroniques 100 et à donner la forme courbe souhaitée à ces composants électroniques.

Le support 102 comporte plusieurs membranes 104, chacune étant destinée à recevoir les composants électroniques (ici formant un imageur CMOS) d'un des circuits électroniques 100 sur une face supérieure 105 d'une des membranes 104. Les bords, ou parties périphériques, des membranes 104 sont reliés à des portions plus épaisses du support 102 qui forment des portions de maintien 106 des membranes 104.

Les membranes 104 peuvent être vues comme étant suspendues aux portions de maintien 106. Chacune des membranes 104 a par exemple, dans le plan principal du support 102 (plan (X,Y) sur la figure 1), une forme sensiblement circulaire ou carré ou rectangulaire.

Chacune des membranes 104 est courbée et présente un rayon de courbure R compris entre environ 15 mm et 500 mm, ou bien compris entre environ 85 mm et 500 mm, ou compris entre environ 250 mm et 500 mm, ou compris entre environ 280 mm et 500 mm.

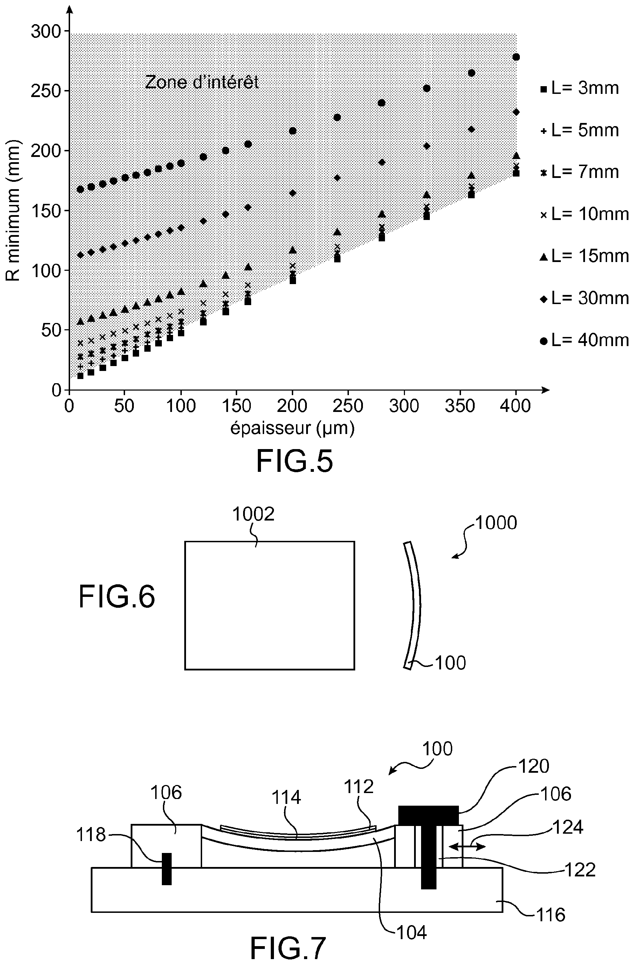

Le rayon de courbure R minimal pouvant être obtenu par ce procédé dépend notamment du matériau et des dimensions du substrat sur lequel sont réalisés les composants électroniques. La figure 5 représente le rayon de courbure R minimal, en mm, pouvant être obtenu lorsque les composants électroniques sont réalisés sur un substrat de silicium aminci, en fonction de l'épaisseur (en microns sur la figure 5) de ce substrat. Ces valeurs sont obtenues en considérant un substrat de silicium de forme carré dont les côtés ont chacun une longueur L. Sur la figure 5, les valeurs de rayon de courbure minimal sont données pour différentes valeurs de L. On voit sur la figure 5 qu'une valeur de R légèrement supérieure à 15 mm est obtenue pour un substrat de silicium de forme carrée de côté de dimension L = 3 mm et d'épaisseur égale à environ 10 µm.

Le support 102 est par exemple réalisé à partir d'un matériau métallique.

Dans ce cas, le support 102 est réalisé par exemple par usinage ou assemblé par emboutissage afin de former des membranes 104 courbées suivant un rayon de courbure R correspondant au rayon de courbure final selon lequel les composants électroniques des circuits électroniques 100 sont destinés à être courbés.

En variante, le matériau du support 102 peut correspondre à un matériau plastique. Dans ce cas, le support 102 peut être réalisé par moulage ou par impression 3D.

Dans tous les cas, que le matériau du support 102 soit métallique ou plastique, ce matériau est choisi tel que sa rigidité, ou module de Young, soit supérieure à environ 100 MPa. Un tel matériau métallique comporte par exemple à de l'acier, et un tel matériau plastique correspond par exemple à un matériau thermoplastique (comprenant par exemple au moins l'un des matériaux suivants : polyéthylène, polypropylène, ABS pour Acrylonitrile Butadiène Styrène, etc.) et/ou thermodurcissable (comprenant par exemple au moins l'un des matériaux suivants : résine époxy, polyester, polyuréthane, etc.).

Une telle rigidité va permettre, ultérieurement au cours du procédé, de courber le substrat semi-conducteur sur lequel les composants électroniques de chaque circuit 100 sont réalisés.

Une force F, schématisée par des flèches portant la référence 108 sur la figure 2, est ensuite appliquée sur l'une des faces principales des membranes 104, correspondant aux faces inférieures 110 des membranes 104 dans cet exemple de réalisation. Cette force F est telle que les membranes 104 soumises à cette force se déforment plastiquement et deviennent sensiblement planes (les faces 105, 110 appartiennent à des plans parallèles au plan principal du support 102 (plan (X,Y))). Cette force F correspond par exemple à une pression hydrostatique appliquée par un fluide sur l'ensemble de la surface de la face inférieure 110 de chacune des membranes 104. Sur chacune des membranes 104, la force F appliquée est par exemple comprise entre 10 kg et 30 kg, la valeur précise dépendant notamment du matériau et des dimensions des membranes 104, ainsi que de la valeur du rayon de courbure R.

L'intensité de la force F à appliquer peut être prédéterminée par calcul analytique, comme décrit dans le document « Development of a variable curvature mirror for the delay lines of the VLT interferometer » de M. Ferrari, Astron. Astrophys. Suppl. ser. 128, 221-227, 1998, partie « optical results », page 225-227. En variante, la force F peut ne pas être prédéterminée à l'avance et être appliquée progressivement contre les membranes 104. L'obtention de la planéité des membranes 104 peut alors être contrôlée dynamiquement par des méthodes de mesures optiques telles qu'une mesure confocale ou par interféromètre de Fizeau, ou de mesures mécaniques telles que qu'une mesure par palpeur ou stylet mécanique.

L'augmentation de la force F est stoppée lorsque la planéité des membranes 104 est obtenue.

Comme représenté sur la figure 3, les composants électroniques 112 des circuits électroniques 100 sont reportés sur les membranes 104 maintenues dans un état plan par la force F. Les composants électroniques 112 de chaque circuit électronique 100 forment par exemple, pour chaque circuit électronique 100, un capteur d'image. Les composants électroniques 112 sont réalisés sur un substrat pouvant être courbé sans se casser, comprenant par exemple un semi-conducteur tel que du silicium, et dont l'épaisseur est par exemple inférieure à environ 400 µm.

Dans le mode de réalisation décrit ici, les composants électroniques 112 sont reportés sur les faces supérieures 105 des membranes 104. Les composants électroniques 112 sont par exemple solidarisés aux membranes 104 par l'intermédiaire d'une couche de solidarisation 114, correspondant par exemple à une couche de colle. La couche de colle 114 a par exemple une épaisseur égale à environ 75 µm, ou plus généralement supérieure à environ 30 µm. Le collage des composants électroniques 112 sur les faces supérieures 105 des membranes 104 peut être réalisé conformément au procédé décrit dans le document EP 3 093 634 A1, et notamment avec une couche de colle présentant un module de Young compris entre environ 20 MPa et 80 MPa, ce qui permet de réduire le risque de casse des circuits électroniques 100, avec une étape ultérieure de durcissement de la colle, par exemple par réticulation ou séchage de la colle.

En variante, toute autre technique de solidarisation peut être utilisée pour le report des composants électroniques 112 contre les membranes 104.

Ensuite, la force F est progressivement retirée et les membranes 104 reprennent progressivement leur forme initiale, imposant ainsi leur rayon de courbure R aux composants électroniques 112 montés sur leur surface sans endommager les circuits électroniques 100 (figure 4). L'énergie élastique accumulée dans les membranes 104 est libérée, mettant en courbure les différents circuits électroniques 100 réalisés.

Grâce à la couche de colle épaisse, les contraintes que subissent les composants électroniques 112 sont réduites lorsque la force F est retirée et que les composants électroniques 112 se courbent. Cela réduit le risque de dégradation des composants électroniques 112.

La réalisation des circuits électroniques 100 est achevée en découpant le support 102 au niveau des différentes portions de maintien 106 sur lesquelles les composants électroniques 112 ne sont pas présents, ce qui désolidarise les circuits électroniques 100 les uns des autres. D'autres étapes de protection des composants électroniques 112 ou de réalisation de câblages filaires peuvent être également mises en œuvre.

En variante du procédé décrit ci-dessus dans lequel la force F applique une pression sur les faces inférieures 110 des membranes 104 lors du report des composants électroniques 112 sur les membranes 104, il est possible que les faces arrières 110 des membranes 104 soient soumises, lors du report des composants électroniques 112, à une force de dépression, par exemple hydrostatique. Ce cas s'applique lorsque la courbure initiale des membranes 104 est opposée à celle décrite précédemment en lien avec la figure 1, c'est-à-dire telle que les faces supérieures 105 aient une forme convexe par rapport au plan principal des membranes 104. La dépression alors appliquée sur les faces arrières 110 des membranes 104 est telle que les membranes 104 se trouvent dans un état de déformation sensiblement plan permettant le report des composants électroniques 112 sur les faces 105 non courbées. Après le retrait de cette force de dépression, les composants électroniques 112 se retrouvent dans un état de courbure convexe (au niveau de leur face supérieure).

Selon une autre variante, il est possible que la force F corresponde à un appui ponctuel appliqué sur la face inférieure 110 de chacune des membranes 104, par exemple au niveau d'une région centrale de la face inférieure 110 de chacune des membranes 104. Dans ce cas, si une courbure sphérique des membranes 104 est souhaitée, chacune des membranes 104 est réalisée avec une épaisseur variable afin de répartir le plus uniformément possible la force ponctuelle sur l'ensemble de chacune des membranes 104. Par exemple, cette épaisseur peut être décroissante depuis le centre de chacune des membranes 104 jusque vers les bords des membranes 104. Autrement dit, l'épaisseur maximale de chaque membrane 104 peut être localisée sensiblement au niveau du centre de chacune des membranes 104, là où la force F est destinée à être appliquée, l'épaisseur minimale se trouvant au niveau des bords des membranes 104 qui sont en contact avec les portions de maintien 106. En variante, il est également possible que les membranes 104 soient telles que les faces supérieures 105 aient une forme convexe par rapport au plan principal des membranes 104, et qu'une force F ponctuelle tirant les membranes 104 au niveau de leur face supérieure 105 soit appliquée.

Selon une autre variante, les courbures des circuits électroniques 100 peuvent être non pas sphériques mais cylindriques (concaves ou convexes). Dans ce cas, pour des raisons d'étanchéité, la force F appliquée pour déformer les membranes 104 lors des reports des composants électroniques 112 correspond à une force d'appui mécanique et non hydrostatique.

Selon une autre variante, il est également possible que les composants électroniques 112 soient reportés sur les faces arrières 110 des membranes 104. Dans ce cas, les membranes 104 sont déformées en appliquant la force F sur les faces avants 105 des membranes 104.

Les circuits électroniques courbés 100 ainsi réalisés sont utilisés pour la réalisation de dispositifs électroniques 1000 tels que celui représenté schématiquement sur la figure 6. Sur cette figure, le dispositif électronique 1000 correspond à un imageur comprenant un circuit électronique courbé 100 formant un capteur d'image couplé optiquement à un système optique 1002 comprenant plusieurs lentilles focalisant une lumière reçue sur les composants électroniques du circuit 100.

Le circuit électronique courbé 100 obtenu peut également être fixé à un support 116, comme représenté par exemple sur la figure 7. Les portions de maintien 106 du circuit électronique 100 sont dans ce cas maintenues au support 116.

Lorsque le support 116 comporte un matériau ayant un CTE différent de celui des portions de maintien 106, il est possible de maintenir le circuit électronique 100 au support 116 par des moyens de maintien particuliers permettant de garantir une insensibilité de la courbure du circuit électronique 100 vis-à-vis des variations de température. Sur l'exemple représenté sur la figure 7, ces moyens de maintien correspondent à un pige de positionnement 118, ou pige de centrage, formant un point de positionnement fixe du circuit électronique 100 sur le support 116, et un autre moyen de fixation 120 maintenant mécaniquement le circuit électronique 100 sur le support 116 tout en autorisant un glissement relatif du circuit électronique 100 sur le support 116 lors d'une variation de température engendrant une dilatation thermique. Sur la figure 7, ce moyen de maintien 120 correspond à une vis 120 et un trou 122 formé dans le circuit électronique et ayant des dimensions plus importantes que celles de la vis 120, autorisant un déplacement représenté symboliquement par la flèche 124.

## Revendications

1. Procédé de réalisation de plusieurs circuits électroniques (100) courbés, comprenant :
- réalisation d'un support (102) comprenant plusieurs membranes (104) formées d'au moins un matériau de rigidité supérieure à environ 100 MPa, chacune destinée à faire partie d'un des circuits électroniques (100) et présentant un rayon de courbure R compris entre environ 15 mm et 500 mm ;
- application d'une force (108) contre l'une des faces principales (110) de chacune des membranes (104) telle que ladite membrane (104) se déforme élastiquement et ait une forme sensiblement plane sous l'effet de cette force ;
- solidarisation d'au moins un composant électronique (112) contre chacune des membranes (104) ;
- retrait de la force (108) appliquée contre l'une des faces principales (110) de chacune des membranes (104) telle que chacune des membranes (104) retrouve son rayon de courbure R initial et courbe le composant électronique (112) selon ce rayon de courbure R.

2. Procédé selon la revendication 1, dans lequel le matériau des membranes (104) est un matériau plastique et le support (102) est réalisé par moulage ou par impression 3D, ou dans lequel le matériau des membranes (104) est un matériau métallique et le support (102) est réalisé par usinage ou par emboutissage.

3. Procédé selon l'une des revendications précédentes, dans lequel la force (108) appliquée contre l'une des faces principales (110) de chacune des membranes (104) est une force hydrostatique appliquée sur l'ensemble de ladite face principale (110), ou une force ponctuelle.

4. Procédé selon l'une des revendications précédentes, dans lequel chacune des membranes (104) a une courbure sphérique ou cylindrique.

5. Procédé selon les revendications 3 et 4, dans lequel, lorsque chacune des membranes (104) a une courbure sphérique et que la force (108) appliquée est ponctuelle, chacune des membranes (104) comporte une épaisseur variable décroissante depuis le centre de la membrane (104) jusque vers les bords de la membrane (104).

6. Procédé selon l'une des revendications précédentes, dans lequel la force (108) est appliquée sur une première des faces principales (110) de chacune des membranes (104) et chaque composant électronique (112) est solidarisé contre une deuxième des faces principales (105) de chacune des membranes (104), opposée à la première des faces principales (110).

7. Procédé selon l'une des revendications précédentes, dans lequel chaque composant électronique (112) est solidarisé contre l'une des membranes (104) par l'intermédiaire d'au moins une couche de collage (114).

8. Procédé selon l'une des revendications précédentes, comportant en outre, après l'étape de retrait de la force (108) appliquée contre l'une des faces principales (110) de chacune des membranes (104), une étape de découpe du support (102) désolidarisant les circuits électroniques (100) les uns des autres.

9. Procédé de réalisation de dispositifs électroniques (1000), comportant la mise en œuvre d'un procédé de réalisation de circuits électroniques (100) selon la revendication 8, puis d'une étape de couplage de chaque circuit électronique (100) avec un système optique (1002), formant les dispositifs électroniques (1000).

## Patentansprüche

1. Verfahren zur Herstellung von mehreren gekrümmten elektronischen Schaltungen (100), umfassend:
- Herstellen eines Trägers (102), der mehrere Membranen (104) umfasst, die aus wenigstens einem Material mit einer Festigkeit größer als ungefähr 100 MPa gebildet sind, von denen jede dazu ausgelegt ist, Teil einer der elektronischen Schaltungen (100) zu sein und einen Krümmungsradius R aufweist, der zwischen ungefähr 15 mm und 500 mm enthalten ist;
- Ausüben einer Kraft (108) gegen die eine der Hauptflächen (110) von jeder der Membranen (104) derart, dass sich die Membran (104) unter der Einwirkung dieser Kraft elastisch verformt und eine im Wesentlichen flache Form hat;
- Befestigen wenigstens einer elektronischen Komponente (112) an jeder der Membranen (104);
- Zurücknehmen der Kraft (108), die gegen die eine der Hauptflächen (110) von jeder Membranen (104) ausgeübt wird, derart, dass jede der Membranen (104) wieder ihren anfänglichen Krümmungsradius R einnimmt und die elektronische Komponente (112) gemäß diesem Krümmungsradius R krümmt.

2. Verfahren nach Anspruch 1, bei dem das Material der Membranen (104) ein Kunststoffmaterial ist und der Träger (102) durch Formen oder durch 3D-Druck hergestellt ist, oder bei dem das Material der Membranen (104) ein Metallmaterial ist, und der Träger (102) durch Bearbeitung oder durch Tiefziehen hergestellt ist.

3. Verfahren nach einem der vorhergehenden Ansprüche, bei dem die Kraft (108), die gegen die eine der Hauptflächen (110) von jeder der Membranen (104) ausgeübt wird, eine hydrostatische Kraft ist, die auf die Gesamtheit der Hauptfläche (110) ausgeübt wird, oder eine punktuelle Kraft.

4. Verfahren nach einem der vorhergehenden Ansprüche, bei dem jede der Membranen (104) eine sphärische oder zylindrische Krümmung hat.

5. Verfahren nach den Ansprüchen 3 und 4, bei dem dann, wenn jede der Membranen (104) eine sphärische Krümmung hat, und die ausgeübte Kraft (108) punktförmig ist, jede der Membranen (104) eine variable Dicke umfasst, die ausgehend vom Zentrum der Membran (104) bis zu den Rändern der Membran (104) abnimmt.

6. Verfahren nach einem der vorhergehenden Ansprüche, bei dem die Kraft (108) auf eine erste der Hauptflächen (110) von jeder der Membranen (104) ausgeübt wird, und jede elektronische Komponente (112) an einer zweiten der Hauptflächen (105) von jeder der Membranen (104) entgegengesetzt zu der ersten der Hauptflächen (110) befestigt wird.

7. Verfahren nach einem der vorhergehenden Ansprüche, bei dem jede elektronische Komponente (112) an der einen der Membranen (104) mittels wenigstens einer Klebschicht (114) befestigt wird.

8. Verfahren nach einem der vorhergehenden Ansprüche, ferner umfassend, nach dem Schritt des Zurücknehmens der Kraft (108), die gegen die eine der Hauptflächen (110) von jeder der Membranen (104) ausgeübt wird, einen Schritt des Schneidens des Trägers (102), wodurch die elektronischen Schaltungen (100) voneinander getrennt werden.

9. Verfahren zur Herstellung von elektronischen Vorrichtungen (1000), umfassend die Durchführung eines Verfahrens zur Herstellung von elektronischen Schaltungen (100) nach Anspruch 8, dann eines Schritts des Koppelns jeder elektronischen Schaltung (100) mit einem optischen System (1002), wodurch die elektronischen Vorrichtungen (1000) gebildet werden.

## Claims

1. Method for producing a plurality of curved electronic circuits (100), comprising:
- producing a support (102) comprising a plurality of membranes (104) made from at least one material having a rigidity greater than about 100 MPa, each intended for being part of one of the electronic circuits (100) and having a radius of curvature R between about 15 mm and 500 mm;
- applying a force (108) to one of the main faces (110) of each of the membranes (104) such that said membrane (104) is deformed elastically and has a substantially planar shape under the effect of this force;
- rigidly connecting at least one electronic component (112) to each of the membranes (104);
- removing the force (108) applied to one of the main faces (110) of each of the membranes (104) such that each of the membranes (104) retrieves its original radius of curvature R and curves the electronic component (112) according to this radius of curvature R.

2. Method according to claim 1, wherein the material of the membranes (104) is a plastic material and the support (102) is produced by moulding or by 3D printing, or wherein the material of the membranes (104) is a metallic material and the support (102) is produced by machining or by embossing.

3. Method according to one of the preceding claims, wherein the force (108) applied to said one of the main faces (110) of each of the membranes (104) is a hydrostatic force applied on all of said main face (110), or a local force.

4. Method according to one of the preceding claims, wherein each of the membranes (104) has a spherical or cylindrical curvature.

5. Method according to claims 3 and 4, wherein, when each of the membranes (104) has a spherical curvature and the force (108) applied is local, each of the membranes (104) includes a decreasing variable thickness from the centre of the membrane (104) to the edges of the membrane (104).

6. Method according to one of the preceding claims, wherein the force (108) is applied on a first of the main faces (110) of each of the membranes (104) and each electronic component (112) is rigidly connected to a second of the main faces (105) of each of the membranes (104), opposite the first of the main faces (110).

7. Method according to one of the preceding claims, wherein each electronic component (112) is rigidly connected to one of the membranes (104) by means of at least one bonding layer (114).

8. Method according to one of the preceding claims, further including, after the step of removing the force (108) applied to one of the main faces (110) of each of the membranes (104), a step of cutting the support (102) detaching the electronic circuits (100) from one another.

9. Method for producing electronic devices (1000), including the implementation of a method for producing electronic circuits (100) according to claim 8, followed by a step of coupling each electronic circuit (100) with an optical system (1002), forming the electronic devices (1000).
